(19) **Europäisches Patentamt / European Patent Office / Office européen des brevets**

(11) **EP 3 414 578 B1**

(12) # FASCICULE DE BREVET EUROPEEN

(45) Date de publication et mention de la délivrance du brevet:
**04.12.2019 Bulletin 2019/49**

(21) Numéro de dépôt: **17703440.2**

(22) Date de dépôt: **10.02.2017**

(51) Int Cl.:
*G01R 19/25* (2006.01)    *G01R 29/12* (2006.01)
*G01R 31/02* (2006.01)    *G01R 31/08* (2006.01)
*H04B 3/46* (2015.01)    *G01R 15/16* (2006.01)

(86) Numéro de dépôt international:
**PCT/EP2017/052951**

(87) Numéro de publication internationale:
**WO 2017/137534 (17.08.2017 Gazette 2017/33)**

(54) **DISPOSITIF DE MESURE D'UNE GRANDEUR ÉLECTRIQUE D'UNE PHASE D'UN COURANT ÉLECTRIQUE ALTERNATIF D'UN RÉSEAU ÉLECTRIQUE AÉRIEN**

VORRICHTUNG ZUR MESSUNG EINER ELEKTRISCHEN MENGE EINER PHASE EINES WECHSELSTROMS EINES FREILEITUNGSSTROMNETZES

DEVICE FOR MEASURING AN ELECTRICAL QUANTITY OF ONE PHASE OF AN AC ELECTRIC CURRENT OF AN OVERHEAD ELECTRICAL NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.02.2016 FR 1651169**

(43) Date de publication de la demande:
**19.12.2018 Bulletin 2018/51**

(73) Titulaire: **Schneider Electric Industries SAS**
**92500 Rueil-Malmaison (FR)**

(72) Inventeurs:
• **CLEMENCE, Michel**
**38050 Grenoble Cedex 09 (FR)**
• **HOUBRE, Pascal**
**38050 Grenoble Cedex 09 (FR)**
• **CONTINI, Erick**
**38050 Grenoble Cedex 09 (FR)**

(74) Mandataire: **Lavoix**
**62, rue de Bonnel**
**69448 Lyon Cedex 03 (FR)**

(56) Documents cités:
US-A1- 2002 171 433    US-A1- 2013 229 735
US-A1- 2014 035 595    US-A1- 2015 077 088

## Description

L'invention concerne un dispositif de mesure d'une grandeur électrique d'une phase d'un courant électrique alternatif dans un réseau électrique aérien. L'invention concerne un procédé de mesure d'une telle grandeur électrique.

De façon connue, il existe des capteurs pour mesurer une grandeur électrique dans un réseau électrique aérien, telle qu'une tension électrique d'une phase d'un courant alternatif circulant dans ce réseau. Par « réseau électrique aérien », on désigne un réseau de transport électrique qui comporte au moins une ligne électrique aérienne, c'est-à-dire un conducteur électrique qui s'étend au-dessus du sol et qui est en contact avec l'air ambiant.

Un exemple d'un tel capteur comporte une plaque métallique disposée entre une ligne électrique aérienne du réseau électrique et la terre. Ce capteur permet de mesurer une grandeur électrique du courant électrique circulant dans la ligne.

Toutefois, la mesure de la grandeur électrique, effectuée par ce capteur, n'est pas toujours fiable.

Les documents suivants sont également connus de l'état de la technique : US-2015/0077088-A1 et US-2014/035595-A1.

Le but de l'invention est alors de proposer un dispositif et un procédé de mesure d'une grandeur électrique d'une phase d'un courant électrique alternatif dans un réseau électrique aérien, permettant de fournir une mesure plus fiable de la grandeur électrique.

A cet effet, l'invention concerne un dispositif de mesure d'une grandeur électrique d'une phase d'un premier courant électrique alternatif dans un réseau électrique aérien, ce dispositif comportant :

- un capteur, configuré pour être accroché à une ligne électrique du réseau électrique aérien, ce capteur comprenant :
  une plaque électriquement conductrice,
  un conducteur électrique, configuré pour raccorder électriquement la plaque à la ligne électrique, pour la circulation du premier courant électrique depuis la ligne électrique à travers le conducteur électrique,
- une unité de calcul, configurée pour déterminer la grandeur électrique à partir d'une valeur du premier courant électrique et d'une valeur d'une capacité électrique entre la plaque et le sol.

Conformément à l'invention le dispositif comporte en outre un générateur, connecté électriquement au conducteur électrique et configuré pour injecter un deuxième courant électrique à travers le conducteur électrique, ce deuxième courant électrique présentant une fréquence différente de la fréquence du premier courant électrique, l'unité de calcul étant en outre configurée pour calculer la valeur de la capacité électrique entre la plaque et le sol en fonction d'une valeur du deuxième courant électrique.

Grâce à l'invention, il est possible d'étalonner le dispositif de mesure avant chaque mesure de la grandeur électrique en mesurant la valeur de la capacité électrique entre la plaque et la terre. En effet, la valeur de la capacité électrique entre la plaque et la terre n'est pas constante et peut varier, de façon importante, en fonction de conditions environnementales, telles que la température ou le taux d'humidité dans l'air entourant la ligne aérienne. La valeur de la capacité électrique fluctue donc au cours du temps, à tel point que la valeur prédéfinie de cette capacité, utilisée pour déterminer la tension électrique, ne correspond plus toujours à la valeur réelle de cette capacité électrique.

Cette mesure est réalisée par l'injection du deuxième courant électrique dont la valeur est connue. Comme ce courant électrique présente une fréquence différente de la fréquence du premier courant électrique, il est mesurable séparément du premier courant électrique.

Selon des aspects avantageux mais non obligatoires de l'invention, un tel dispositif de mesure comporte une ou plusieurs des caractéristiques suivantes, prises selon toute combinaison techniquement possible :

- une deuxième plaque électriquement conductrice, et
- un deuxième conducteur électrique, configuré pour raccorder électriquement la deuxième plaque à la ligne électrique pour la circulation d'au moins une partie du premier courant électrique depuis la ligne électrique vers la deuxième plaque à travers le deuxième conducteur électrique, le deuxième conducteur électrique étant raccordé électriquement en sortie du générateur pour la circulation d'au moins une partie du deuxième courant injecté à travers le deuxième conducteur ;
- un premier appareil de mesure configuré pour mesurer le premier courant électrique et le deuxième courant électrique circulant à travers le conducteur électrique ;
- premier conducteur électrique présente une première résistance électrique, le premier appareil de mesure comportant un premier capteur de tension pour mesurer la tension électrique aux bornes de la première résistance électrique ;
- un deuxième appareil de mesure configuré pour mesurer le premier courant électrique et le deuxième courant électrique circulant à travers le deuxième conducteur électrique ;
- le deuxième conducteur électrique présente une deuxième résistance électrique, le deuxième appareil de mesure comportant un deuxième capteur de tension pour mesurer la tension électrique aux bornes de la deuxième résistance électrique ;
- la capacité électrique $C_{pt}$ est calculée par l'unité de calcul selon l'équation :

$$C_{pt} = \frac{U_{m1} - U_{m2}}{\omega \times R_m \left(1 - K'\right) \times \left(U_p - U_{m1}\right)}$$

où $U_{m1}$ et $U_{m2}$ sont, respectivement, les tensions électriques mesurées par les premier et deuxième appareils de mesure, $\omega$ est la pulsation du courant alternatif circulant dans le réseau électrique aérien, $U_p$ est la tension électrique aux bornes du générateur injectant le deuxième courant électrique, $R_m$ est égal à la valeur de la première résistance et $K'$ est une valeur numérique qui dépend du rapport entre la distance d'et la distance d, d étant la distance entre la première plaque et la ligne électrique et d' étant la distance entre la deuxième plaque et la ligne électrique ;

- lorsque le premier et le deuxième capteurs sont accrochés à la ligne électrique, le dispositif comporte des première et deuxième capacités électriques parasites qui relient, respectivement, les première et deuxième plaques à la ligne électrique et autorisent la circulation, depuis la ligne électrique, de premier et deuxième courants électriques de fuite ;
- la valeur $K'$ est égale au rapport entre le deuxième et premier courants électriques de fuite ;
- la fréquence du deuxième courant électrique injecté est comprise entre 1 kHz et 1 MHz, de préférence entre 10 kHz et 100 kHz ;
- la grandeur électrique est la tension de la phase du courant alternatif.

Selon un autre aspect, l'invention concerne un procédé de mesure d'une grandeur électrique d'une phase d'un premier courant électrique alternatif dans un réseau électrique aérien, ce procédé comportant :

a) l'accrochage d'un capteur à une ligne électrique aérienne du réseau électrique, ce capteur comprenant :

- une plaque électriquement conductrice,
- un conducteur électrique, configuré pour raccorder électriquement la plaque à la ligne électrique, de sorte que le premier courant électrique circule depuis la ligne électrique au travers du conducteur électrique,

b) la mesure du premier courant électrique circulant au travers du conducteur électrique, au moyen d'un appareil de mesure,
c) le calcul de la grandeur électrique, au moyen d'une unité de calcul, à partir du premier courant électrique mesuré et de la valeur de la capacité électrique entre la plaque et le sol,

caractérisé en ce que le procédé comporte, préalablement à l'accrochage, une séquence d'étalonnage pour déterminer une valeur de la capacité électrique, cette séquence d'étalonnage comprenant :

i) l'injection, au moyen d'un générateur, d'un deuxième courant électrique au travers du conducteur électrique, ce deuxième courant électrique présentant une fréquence différente de la fréquence du premier courant électrique,
ii) la mesure, à l'aide de l'appareil de mesure, du deuxième courant électrique circulant dans le conducteur électrique,
iii) la détermination via l'unité de calcul et en fonction du deuxième courant électrique mesuré, de la valeur de la capacité électrique.

L'invention sera mieux comprise et d'autres avantages de celle-ci apparaîtront plus clairement à la lumière de la description qui va suivre, d'un mode de réalisation d'un dispositif de mesure donnée uniquement à titre d'exemple non limitatif et faite en référence aux dessins annexés dans lesquels :

- la figure 1 représente schématiquement une portion d'un réseau électrique aérien pourvu d'un dispositif selon un premier mode de réalisation de l'invention pour mesurer une grandeur électrique d'une phase d'un courant électrique alternatif de ce réseau ;
- la figure 2 représente schématiquement une unité de calcul du dispositif de mesure de la figure 1 ;
- la figure 3 est un ordinogramme d'un procédé de mesure d'une grandeur électrique d'une phase d'un courant électrique alternatif au moyen du dispositif de mesure de la figure 1 ;
- la figure 4 représente schématiquement une portion d'un réseau électrique aérien pourvu d'un dispositif selon un autre mode de réalisation de l'invention pour mesurer une grandeur électrique d'une phase d'un courant électrique alternatif de ce réseau.

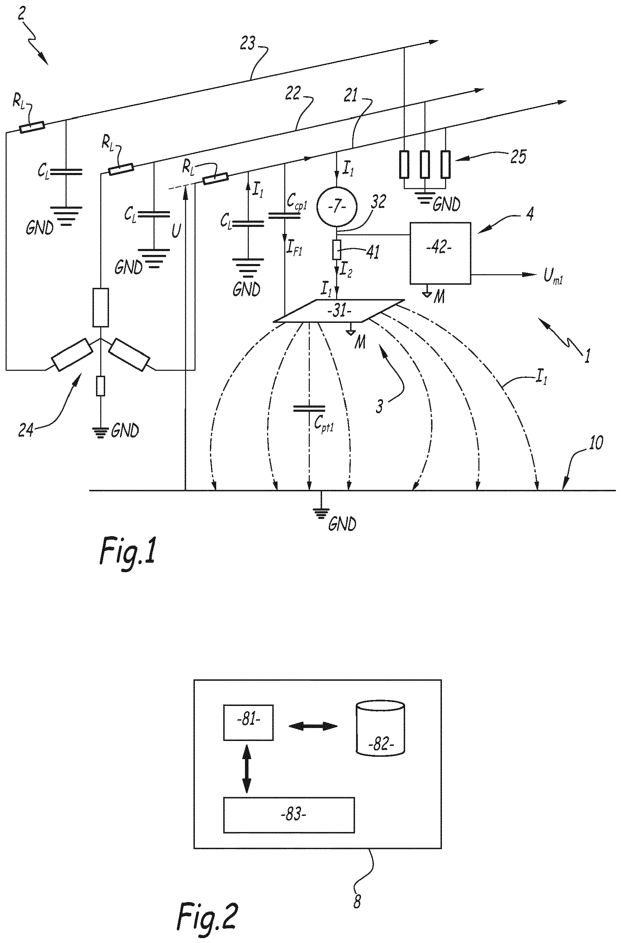

La figure 1 représente un dispositif 1 de mesure d'une grandeur électrique d'une phase d'un courant alternatif dans un réseau électrique aérien 2.
Le réseau 2 est configuré pour transporter un courant électrique alternatif. Par exemple, le réseau 2 est un réseau de distribution électrique à moyenne tension. Dans cet exemple, ce courant électrique alternatif est un courant triphasé et présente une fréquence de 50Hz. En variante, ce courant présente une fréquence de 60 Hz.
Par exemple, le réseau 2 comporte trois lignes électriques aériennes 21, 22, 23, pour acheminer respectivement trois phases électriques du courant électrique alternatif triphasé décrit précédemment. Ces trois lignes 21, 22, 23 sont supposées identiques. Aussi, seule la ligne 21 est décrite en détail dans ce qui suit.
La ligne 21 raccorde électriquement une source électrique 24 du réseau 2 à une charge électrique 25 à alimenter. La source 24 génère le courant électrique alternatif tandis que la charge 25 consomme ce courant.

La source 24 comporte ici un transformateur haute tension - moyenne tension. De façon connue, on modélise les propriétés électriques de la ligne 21 au moyen d'une impédance de ligne $R_L$, placée en série entre la source 24 et la charge 25 et d'une capacité de ligne $C_L$, qui raccorde électriquement la ligne 21 au sol 10.

La ligne 21 s'étend dans l'air et au-dessus du sol 10. Elle s'étend à une hauteur H par rapport au sol 10. La hauteur H est mesurée entre la ligne 21 et le sol 10 le long d'un axe vertical (non illustré), au niveau de l'emplacement où est positionné le dispositif 1. La hauteur H est par exemple supérieure ou égale à 3m, de préférence encore supérieure ou égale à 5m. Ici, la hauteur H est égale à 10m.

Dans cet exemple, la grandeur électrique que l'on souhaite déterminer à l'aide du dispositif 1 est la tension électrique U de la phase électrique associée à la ligne 21, par rapport au sol 10. Le sol 10 est ici raccordé électriquement à la masse électrique GND.

Le dispositif 1 comporte un capteur 3, un générateur 7 et une unité de calcul 8.

Le capteur 3 comporte une plaque 31 électriquement conductrice et un conducteur électrique 32. Le capteur 3 est en outre configuré pour être accroché à la ligne 21 et, en alternance, décroché de la ligne 21. Pour ce faire, il comporte un dispositif d'accrochage à la ligne 21, tel qu'une pince ou un crochet.

Le conducteur 32 raccorde électriquement la plaque 31 à la ligne électrique 21. Il permet la circulation d'un courant électrique $I_1$ depuis la ligne 21 vers la première plaque 31 lorsque le capteur 3 est accroché à la ligne 21. La fréquence du courant $I_1$ est ici égale à la fréquence du courant électrique triphasé circulant dans le réseau 2. Cette fréquence est par exemple égale à 50 Hz.

On note « d » la distance entre la plaque 31 et la ligne 21 lorsque le capteur 3 est accroché à la ligne 21. Cette distance d est mesurée entre la ligne 21 et le centre géométrique de la première plaque 31. Avantageusement, la distance d est inférieure à 5% ou à 2% de la hauteur H. De préférence, la distance d est comprise entre 1 cm et 1 m, par exemple égale à 10 cm.

On note « D » la distance entre la plaque 31 et le sol 10 lorsque le capteur 3 est accroché à la ligne 21. La distance D est mesurée le long de l'axe vertical entre le centre géométrique de la plaque 31 et le sol 10. Par exemple, la distance D est au moins supérieure à 50% de la hauteur H.

La plaque 31 forme un condensateur avec une capacité électrique $C_{pt1}$ par rapport au sol 10, dite capacité plaque-terre. Ainsi, lorsque le capteur 3 est accroché à la ligne 21, la capacité de ligne $C_L$, d'une part, et l'ensemble formé du conducteur 32, de la plaque 31 et donc de la capacité plaque-terre $C_{pt1}$, d'autre part, sont raccordés en parallèle entre la ligne 21 et le sol 10. Le courant électrique $I_1$ circule depuis la ligne 21 jusque dans la plaque 31 et circule ensuite jusqu'à la masse GND via la capacité plaque-terre $C_{pt1}$, puis jusqu'à la ligne 21 par l'intermédiaire de la capacité de ligne $C_L$ Lorsque seul le courant $I_1$ circule dans le dispositif 1, sa valeur est ainsi donnée par la formule :

$$U = \frac{I_1}{\omega \times C_{pt1}} \qquad (1)$$

où $\omega$ est la pulsation du courant électrique alternatif circulant dans le réseau 2.

La valeur de la capacité plaque-terre $C_{pt1}$ dépend par exemple des dimensions de la plaque 31, de la distance D et de propriétés diélectriques du milieu séparant la plaque 31 du sol 10, ici de l'air. Ces propriétés diélectriques dépendent des conditions environnementales, telles que la température ou le taux d'humidité de l'air autour de la plaque 31. Dans cet exemple, la valeur de la capacité plaque-terre $C_{pt1}$ est inférieure ou égale à 10 picoFarad, de préférence inférieure ou égale à 1 picoFarad, et est supérieure ou égale 10 femtoFarad, de préférence supérieure ou égale à 100 femtoFarad.

La plaque 31 présente ici une forme plane. En variante, la plaque 31 présente une forme différente, par exemple incurvée. La superficie de la plaque 31 est ici inférieure à 100cm², voire à 50cm², par exemple égale à 12cm².

La plaque 31 est formée d'un matériau électriquement conducteur, tel que du métal. Ici, une couche métallique est déposée sur un support non métallique, tel qu'une plaque de résine époxy.

Du fait de cette dépendance de la valeur de la capacité plaque-terre $C_{pt1}$ aux conditions environnementales, la mesure du seul courant électrique $I_1$ n'est pas suffisante pour obtenir une détermination précise de sa valeur.

Pour ce faire, un courant électrique $I_2$ est injecté au travers du conducteur 32 puis mesuré séparément du courant $I_1$. Le courant $I_2$ présente une fréquence différente de la fréquence du courant $I_1$. Par exemple, le courant $I_2$ présente une fréquence comprise entre 1 kHz et 1 MHz, de préférence entre 10 kHz et 100 kHz. Dans cet exemple, le courant $I_1$ présente une fréquence égale à 50 kHz.

A cet effet, le générateur 7 est connecté électriquement au conducteur 32 ainsi qu'à la ligne 21. Plus précisément, il relie la ligne 21 en série avec une extrémité du conducteur 32. Le conducteur 32 n'est donc pas ici directement raccordé à la ligne 21.

Ce générateur 7 comporte par exemple un générateur d'impulsions commandable, alimenté électriquement par un circuit d'alimentation dédié (non illustré sur la figure 1). On note « $U_p$ » la tension électrique aux bornes du générateur injectant le courant $I_2$.

Le dispositif 1 comporte en outre un appareil de mesure 4, configuré pour mesurer le courant électrique circulant au travers du conducteur 32. Dans cet exemple, le conducteur 32 comporte une résistance électrique 41 qui présente une valeur $R_m$ connue. L'appareil 4 comporte un capteur de tension 42 pour mesurer une tension électrique aux bornes de la résistance 41. Une tension électrique $U_1$ s'établit aux bornes de cette résistance 41 lorsqu'un courant électrique circule au travers du conducteur 32. De préférence, la résistance $R_m$ ne dépend pas de la fréquence.

L'appareil 4 comporte en outre un circuit de filtrage en fréquence du courant mesuré dans le conducteur 32. Ce circuit de filtrage est apte à éliminer sélectivement, du courant mesuré dans le conducteur 32, des composantes de ce courant ayant une ou plusieurs fréquences prédéfinies. Cela permet alors de mesurer séparément les courants $I_1$ et $I_2$ de fréquences différentes. Ici, ce circuit de filtrage est intégré au capteur de tension 42.

Dans cet exemple, l'appareil 4 présente un gain G de mesure. Le gain G est ici égal au rapport, ou ratio, entre la tension $U_{m1}$ donnée par l'appareil 4 comme résultat de la mesure et la tension $U_1$ aux bornes de la résistance 41. Ce gain G a une valeur connue et ajustable lors de la fabrication du dispositif 1.

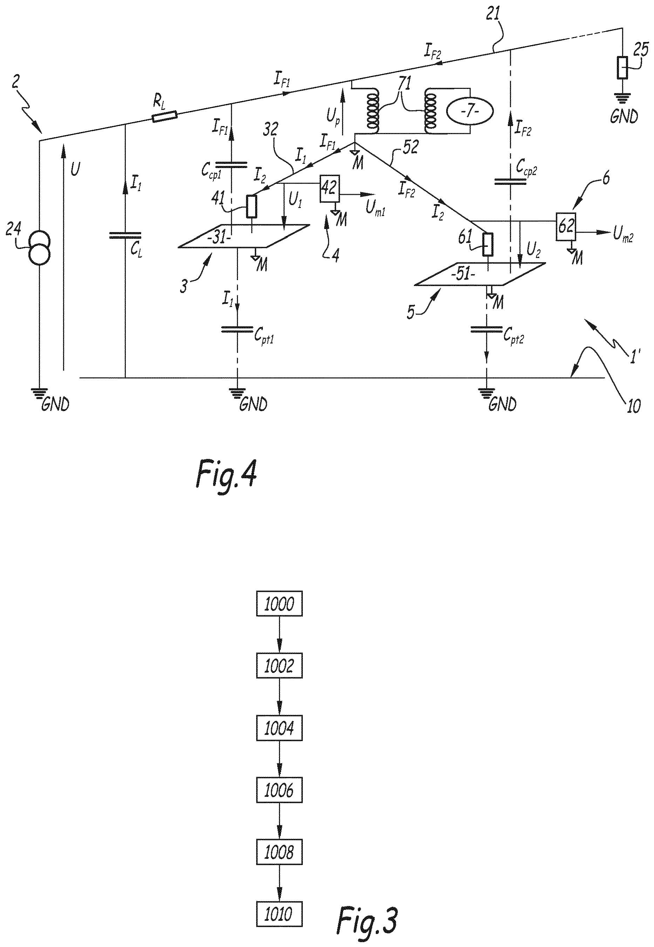

La figure 2 représente une unité électronique de calcul 8 du dispositif 1. Cette unité 8 comporte un calculateur électronique 81, un support d'enregistrement d'informations 82 et une interface d'échange de données 83 qui communiquent ensemble via un bus d'échange de données de l'unité 8. Le calculateur 81 est configuré pour exécuter des instructions contenues dans le support 82. Par exemple, il s'agit d'un microprocesseur. Le support 82 enregistre des instructions pour l'exécution du procédé de la figure 3 lorsqu'elles sont exécutées par le calculateur 81. Par exemple, le support 82 comporte un module de mémoire non-volatile, tel qu'un module Flash ou EEPROM. L'interface 83 permet un échange de données entre l'unité 8, l'appareil 4 et le générateur 7, auxquels elle est connectée par des liaisons de données non illustrées.

L'unité 8 est configurée pour calculer la valeur de la capacité plaque-terre $C_{pt}$. L'unité 8 est en outre configurée pour calculer la tension électrique U de la phase du courant circulant dans la ligne 21 à partir des valeurs du courant $I_1$ mesurées par l'appareil 4, ainsi que de la capacité plaque-terre $C_{pt1}$ calculée. Ce calcul de la valeur de la capacité plaque-terre $C_{pt1}$ est ici réalisé selon la formule :

$$U_p = \frac{I_2}{\omega \times C_{pt1}} \qquad (2)$$

L'injection du courant $I_2$, avec une amplitude connue, permet de mesurer la valeur de la capacité plaque-terre $C_{pt1}$ avant une mesure de la tension U, de manière à prendre en compte une valeur actualisée de la capacité plaque-terre $C_{pt1}$ lors de la détermination de la tension U. De cette manière, le dispositif 1 est étalonné facilement et simplement, pour obtenir une mesure plus fiable de la tension U. Au contraire, dans l'état de la technique, la détermination de la tension U se fait avec une valeur prédéfinie de la capacité plaque-terre $C_{pt1}$.

Le choix d'une fréquence du courant $I_2$ différente de celle du courant $I_1$ permet de mesurer séparément ces courants $I_1$ et $I_2$ à l'aide du même appareil 4.

Un exemple de fonctionnement du dispositif 1 pour mesurer la tension électrique U de la phase électrique associée à la ligne 21 va maintenant être décrit en référence à l'ordinogramme de la figure 3 et à l'aide des figures 1 et 2.

Initialement, lors d'une étape 1000, le dispositif 1 est connecté à la ligne 21. Par exemple, le capteur 3 est accroché à la ligne 21, au moyen du dispositif d'accrochage. Une fois ce capteur 3 accroché, le courant $I_1$ circule depuis la ligne 21 vers la plaque 31.

Ensuite, lors d'une étape 1002, le courant électrique $I_2$ est injecté par le générateur 7 au travers du conducteur 32. Par exemple, l'unité 8 commande le générateur 7 pour qu'il génère une ou plusieurs impulsions électriques entre ses bornes avec la tension $U_p$. Le courant $I_2$ circule ensuite en direction de la ligne 21 par l'intermédiaire de la plaque 31, de la masse électrique GND, de la capacité plaque-terre $C_{pt1}$ et de la capacité de ligne $C_L$.

Lors d'une étape 1004, le courant électrique $I_2$ injecté est mesuré dans le conducteur 32, via l'appareil de mesure 4. Par exemple, le capteur de tension 42 mesure la tension $U_1$, qui correspond à la superposition des courants $I_1$, $I_2$ circulant dans le conducteur 32. La tension $U_1$ mesurée est alors filtrée en fréquence pour en éliminer la composante à basse fréquence qui correspond au courant $I_1$, par exemple avec une fréquence de coupure égale à 1 kHz pour éliminer les composantes correspondant à des fréquences inférieures à 1kHz. Le capteur de tension 42 délivre ensuite la valeur $U_{m1}$ comme résultat de la mesure.

Lors d'une étape 1006 suivante, l'unité 8 détermine la valeur de la capacité plaque-terre $C_{pt1}$ en fonction des courants mesurés par l'appareil 4 lors de l'étape 1004. Par exemple, la tension $U_{m1}$ est acquise par l'unité 8. L'unité 8 calcule ensuite la valeur de la capacité plaque-terre $C_{pt1}$ selon l'équation (2) précédemment mentionnée.

Ces étapes 1002, 1004 et 1006 forment ainsi une séquence d'étalonnage du dispositif 1, pour actualiser la valeur de la capacité plaque-terre $C_{pt1}$. De cette façon, les étapes ultérieures du procédé sont réalisées avec la valeur de capacité actualisée.

Lors d'une étape ultérieure 1008, la valeur du courant $I_1$ circulant dans le conducteur 32 est mesurée à l'aide de l'appareil 4. A ce stade, il n'est plus nécessaire d'injecter le courant $I_2$. Par exemple, le générateur 7 est arrêté. Par exemple, le capteur de tension 42 mesure la tension $U_1$ aux bornes du conducteur 32. Le signal mesuré est filtré en fréquence pour éliminer la composante à haute fréquence et ne conserver ainsi que la composante qui correspond au courant $I_1$, par exemple avec une fréquence de coupure égale à 1 kHz. Le capteur de tension 42 délivre alors la valeur $U_{m1}$ comme résultat de la mesure.

Enfin, lors d'une étape 1010, la tension U est déterminée par l'unité 8 à partir du courant $I_1$ mesuré par l'appareil 4 lors de l'étape 1008 et de la valeur de la capacité plaque-terre $C_{pt1}$ calculée lors de l'étape 1006. Par exemple, la valeur de tension $U_{m1}$ mesurée lors de l'étape 1008 est acquise par l'unité 8. Le calcul de la tension U est alors effectué selon l'équation (1) précédemment définie.

Bien que la détermination de la capacité plaque-terre $C_{pt1}$ soit améliorée grâce au dispositif 1, elle est susceptible d'être encore améliorée. En effet, lorsque le capteur 3 est accroché à la ligne 21, il se forme une première capacité électrique parasite $C_{cp1}$ entre la plaque 31 et la ligne 21. Cette première capacité parasite $C_{cp1}$ engendre la circulation d'un premier courant électrique de fuite $I_{F1}$ circulant depuis la ligne 21 via le conducteur 32 et la plaque 31 vers la ligne 21. L'intensité du premier courant de fuite $I_{F1}$ dépend de la valeur de la première capacité parasite $C_{cp1}$. La valeur de la première capacité parasite $C_{cp1}$ est notamment fonction de la distance d entre la première plaque 31 et la ligne 21. Le premier courant de fuite $I_{F1}$ présente une fréquence supérieure à celle du courant $I_1$. La première capacité parasite $C_{cp1}$ correspond à une somme de plusieurs capacités parasites.

La figure 4 représente un dispositif 1' de mesure de la grandeur électrique dans le réseau électrique aérien 2, qui remplace avantageusement le dispositif 1 en améliorant encore la détermination de la première capacité plaque-terre $C_{pt1}$. Pour simplifier la figure 4, les lignes 22 et 23 ne sont pas représentées. Le dispositif 1' comporte le capteur 3, appelé par la suite premier capteur 3, et un deuxième capteur 5, le générateur 7 et l'unité de calcul 8.

Dans ce qui suit, de manière analogue, la plaque 31 et le conducteur 32 sont nommés respectivement « première plaque 31 » et « premier conducteur 32 », la capacité plaque-terre $C_{pt1}$ est nommée « première capacité $C_{pt1}$ » et l'appareil 4 est nommé « premier appareil 4 ».

Le deuxième capteur 5 comporte une deuxième plaque électriquement conductrice 51 et un deuxième conducteur électrique 52. Le deuxième capteur 5 est en outre configuré pour être accroché à la ligne 21.

Dans cet exemple, les capteurs 3 et 5 sont raccordés mécaniquement l'un avec l'autre. Par exemple, ils sont logés à l'intérieur d'un même boîtier (non illustré) du dispositif 1. Ainsi, les capteurs 3 et 5 sont accrochés à la ligne 21 simultanément, par exemple grâce au dispositif d'accrochage du premier capteur 3. En variante, ce dispositif d'accrochage appartient au deuxième capteur 5 ou bien est à l'extérieur des capteurs 3 et 5. En variante, chacun des capteurs 3 et 5 comporte son propre dispositif d'accrochage.

Ici, les capteurs 3 et 5 sont identiques et se distinguent seulement par leur position respective par rapport à la ligne 21.

Le deuxième capteur 5 est accroché à la ligne 21 à une distance « d' » différente de la distance d. On note D' la hauteur par rapport au sol 10 du deuxième capteur 5.

On note K le rapport, ou ratio, entre la distance d'et la distance d. Ce rapport K est strictement supérieur à 1. Par exemple, il est compris entre 2 et 50, et, préférentiellement, entre 2 et 10. Dans cet exemple, le rapport K est égal à 2.

Avantageusement, les capteurs 3 et 5 sont placés de manière fixe l'un par rapport à l'autre au sein du dispositif 1' de telle sorte que les distances d et d'et que le rapport K ne varient pas une fois que les capteurs 3 et 5 sont tous deux accrochés à la ligne 21.

La deuxième plaque 51 et le deuxième conducteur 52 jouent le même rôle, respectivement, que la plaque 31 et le deuxième conducteur 32. Tout ce qui a été décrit en référence à la première plaque 31 et au premier conducteur 32 s'applique, respectivement, à la deuxième plaque 51 et au deuxième conducteur 52.

Ainsi, le deuxième conducteur 52 raccorde électriquement la deuxième plaque 51 à la ligne 21, pour la circulation d'au moins une partie du courant électrique $I_1$ depuis la ligne 21 vers la deuxième plaque 51. De la même façon, la deuxième plaque 51 définit une capacité électrique $C_{pt2}$ par rapport au sol 10, dite deuxième capacité plaque-terre. Ainsi, lorsque le deuxième capteur 5 est accroché à la ligne 21, la capacité de ligne $C_L$, d'une part, et l'ensemble formé du deuxième conducteur 52, de la deuxième plaque 51 et de la deuxième capacité plaque-terre $C_{pt2}$, d'autre part, sont raccordés en parallèle entre la ligne 21 et le sol 10. Ainsi, lorsque seul le courant $I_1$ circule dans le deuxième conducteur 52, sa valeur est donnée par la formule :

$$U = \frac{I_1}{\omega \times C_{pt2}} \qquad (3)$$

La valeur de la deuxième capacité plaque-terre $C_{pt2}$ dépend par exemple de la distance D' et des propriétés diélectriques du milieu séparant la deuxième plaque 51 du sol 10.

De même, on note $C_{cp2}$ une deuxième capacité parasite entre la deuxième plaque 51 et la ligne 21. Cette deuxième capacité parasite $C_{cp2}$ permet la circulation d'un deuxième courant électrique de fuite $I_{F2}$ le long du deuxième conducteur 52 et de la deuxième plaque 51 vers la ligne 21. L'intensité du deuxième courant de fuite $I_{F2}$ dépend de la valeur de la deuxième capacité parasite $C_{cp2}$. La valeur de la deuxième capacité parasite $C_{cp2}$ est par exemple fonction de la distance d' entre la plaque 51 et la ligne 21.

Compte tenu de la valeur du rapport K et de la valeur de la distance d par rapport à la hauteur H de la ligne 21, la distance D' est ici du même ordre de grandeur que la distance D, c'est-à-dire égale à 10% près, voire à 5% près, voire encore à 2% près. De plus, du fait que les capteurs 3 et 5 sont situés proches l'un de l'autre, par exemple à une distance inférieure à 1m, les propriétés diélectriques du milieu séparant les plaques 31 et 51 du sol sont essentiellement les mêmes. De plus, les plaques 31 et 51 sont ici identiques. Il en résulte que les valeurs des première et deuxième capacités plaque-terre $C_{pt1}$ et $C_{pt2}$ sont très proches l'une de l'autre et varient de concert l'une avec l'autre lorsque les propriétés diélectriques de l'air varient. Ces première et deuxième capacités plaque-terre $C_{pt1}$ et $C_{pt2}$ sont alors considérées égales à une même valeur de capacité plaque-terre $C_{pt}$. Dans ce qui suit et sauf mention contraire, le dispositif 1' cherche à déterminer cette valeur de capacité plaque-terre $C_{pt}$.

Les première et deuxième capacités parasites $C_{cp1}$ et $C_{cp2}$ présentent ici des valeurs différentes dont le rapport reste de préférence constant au cours du temps. Le rapport entre les valeurs des première et deuxième capacités parasites $C_{cp2}$ et $C_{cp1}$ est fonction du rapport K. En théorie, dans le cas où les plaques 31 et 51 sont rigoureusement identiques et présentent une même orientation vers la ligne 21, ce rapport entre les valeurs des première et deuxième capacités parasites $C_{cp2}$ et $C_{cp1}$ est proportionnel au rapport K. Cependant, en pratique, les plaques 31 et 51 ne sont pas toujours identiques, ni orientées de la même façon vers la ligne 21. Ce rapport n'est alors pas rigoureusement proportionnel au rapport K. Dans cet exemple, ce rapport est proportionnel au rapport K à 10% près, ou à 20% près, ou encore à 30% près.

On note K' le rapport, en ratio, entre le deuxième courant de fuite $I_{F2}$ et le premier courant de fuite $I_{F1}$. Le rapport K' présente donc ici une valeur qui dépend du rapport K.

En pratique, la valeur du rapport K' est prédéfinie, par exemple lors d'une phase finale de fabrication du dispositif 1'. Pour ce faire, une tension connue est mesurée à l'aide du dispositif 1', et la valeur du rapport K' est déterminée au moyen de l'équation (5) décrite ci-après. La valeur du rapport K' ainsi déterminée est enregistrée, par exemple, au sein de l'unité 8, et les valeurs des gains G et G' sont réglées en conséquence. Puisque le support K n'est pas supposé varier lors du fonctionnement du dispositif 1', la valeur du support K' ainsi déterminée est utilisable par la suite.

Dans cet exemple, le générateur 7 est connecté électriquement aux conducteurs 32 et 52 ainsi qu'à la ligne 21. Plus précisément, il relie la ligne 21 en série avec un point de jonction entre les extrémités respectives des conducteurs 32 et 52. Les conducteurs 32 et 52 ne sont donc pas ici directement raccordés à la ligne 21. Ici, la connexion du générateur 7 à la ligne 21 et aux capteurs 3 et 5 est réalisée au moyen d'un transformateur 71. Des bornes de sortie du générateur 7 sont raccordées à un premier enroulement du transformateur 71. Ce premier enroulement est couplé à un second enroulement du transformateur 71 qui raccorde la ligne 21 à un point de jonction entre les extrémités respectives des conducteurs 32 et 52. Ce point de jonction est ici raccordé à une masse électrique flottante M. En variante, le transformateur 71 n'est pas présent. Le générateur 7 est alors connecté directement en série entre la ligne 21 et le point de jonction.

Avantageusement, le rapport, ou ratio, entre, d'une part, la distance entre le générateur 7 et la première plaque 31 et, d'autre part, entre le générateur 7 et la deuxième plaque 51 est égal, à 5% près, voire à 2% près, au rapport K'. De cette manière, le couplage électrique entre le générateur 7 et la deuxième plaque 51 est proportionnel, avec un coefficient de proportionnalité égal au rapport K', au couplage électrique entre le générateur 7 et la première plaque 31.

Le dispositif 1' comporte en outre un deuxième appareil de mesure 6. Ces premier et deuxième appareils 4 et 6 sont ici à l'intérieur du boîtier du dispositif 1'. En variante, les premier et deuxième appareils 4 et 6 sont disposés à l'extérieur du boîtier du dispositif 1'.

Le deuxième appareil 6 est configuré pour mesurer les courants électriques circulant au travers du deuxième conducteur 52. Le deuxième appareil 6 comporte ici un deuxième capteur de tension 62. Le deuxième appareil 6 joue vis-à-vis du deuxième conducteur 52 le même rôle que le premier appareil 4 vis-à-vis du premier conducteur 32. Par exemple, le deuxième appareil 6 est identique au premier appareil 4, à la seule différence que le deuxième appareil 6 présente un gain de mesure noté G'.

Dans cet exemple, le deuxième conducteur 52 présente une résistance électrique 61 de valeur $R'_m$ connue. On note $U_2$ la tension électrique aux bornes de cette résistance 61 lorsqu'un courant circule dans le deuxième conducteur 52 et « $U_{m2}$ » le résultat de la mesure de cette tension $U_2$. Le gain G' est donc égal au rapport entre $U_{m2}$ et $U_2$.

Avantageusement, les valeurs $R_m$ et $R'_m$ des résistances 41 et 61 ainsi que les gains G et G' sont choisies tels que :

$$\frac{R'_m}{R_m} \times \frac{G'}{G} = K' \qquad (4)$$

à 5% près, voire à 2% près.

Dans cet exemple, les valeurs des gains G et G' sont égales. Dans ce cas, le ratio des valeurs $R'_m$ et $R_m$ est égal à 5% près, voire à 2% près, au rapport K'.

En variante, les valeurs des résistances $R_m$ et $R'_m$ sont égales. Le ratio entre le gain G' et le gain G est égal à 5% près, voire à 2% près, au rapport K'. Les valeurs de gains G et G' sont par exemple réglées à une valeur souhaitée lors de la fabrication du dispositif 1' et ne sont plus modifiées ensuite. En variante, les gains G et G' ne sont pas incorporés dans les appareils 4 et 6 mais sont ajoutés lors du traitement, par l'unité 8, des données mesurées par ces appareils 4 et 6.

Les appareils 4 et 6 sont alimentés électriquement au moyen d'un circuit d'alimentation distinct de l'alimentation du générateur 7, par exemple un circuit commun aux appareils 4 et 6 et qui est relié à la masse électrique M.

Avantageusement, le dispositif 1' comporte un matériau dont le coefficient de permittivité ne varie pas au cours du temps et entourant les plaques 31 et 51. Par exemple, l'intérieur du boîtier du dispositif 1' est rempli d'une mousse synthétique. Cela permet d'éviter que les valeurs des capacités parasites varient de façon incontrôlée ou indépendante l'une de l'autre, au cas où les propriétés diélectriques de l'air environnant autour de la ligne 21 et des plaques 31 et 51 varieraient.

Dans cet exemple, l'unité 8 est en outre configurée pour calculer la valeur de la capacité plaque-terre $C_{pt}$. L'unité 8 est par exemple logée à l'intérieur du boîtier du dispositif 1'. En variante, l'unité 8 est déportée à l'extérieur de ce boîtier. L'unité 8 est en outre configurée pour calculer la tension électrique U de la phase du courant circulant dans la ligne 21 à partir des valeurs du courant $I_1$ mesurées par les appareils 4 et 6, ainsi que de la capacité plaque-terre $C_{pt}$ calculée. Ce calcul de la valeur de la capacité plaque-terre $C_{pt}$ est ici réalisé selon la formule :

$$C_{pt} = \frac{U_{m1} - U_{m2}}{\omega \times R_m \, (1 - K') \times (U_p - U_{m1})} \qquad (5)$$

Le dispositif 1' permet ainsi de calculer la valeur de la capacité plaque-terre $C_{pt}$ sans prendre en compte des courants de fuite parasites qui se superposent au courant $I_2$ lors de la mesure de ce courant $I_2$. En effet, les courants de fuite $I_{F1}$ et $I_{F2}$, dus aux capacités parasites $C_{cp1}$ et $C_{cp2}$, présentent une fréquence du même ordre de grandeur que celle du courant $I_2$. Comme ces courants de fuite $I_{F1}$ et $I_{F2}$ viennent se superposer au courant électrique $I_2$ injecté, ils sont mesurés en même temps que le courant $I_2$ et n'en sont pas distingués. Cela introduit une erreur sur la valeur de la capacité plaque-terre $C_{pt}$ calculée. Grâce au choix des valeurs de gain G, G' et des résistances $R_m$ et $R'_m$ selon le rapport K', les composantes du courant électrique mesurées dans les conducteurs 32 et 52 liés à ces courants parasites et superposées au courant $I_2$ sont simplement éliminées en calculant la différence entre les valeurs de tension mesurées $U_{m2}$ et $U_{m1}$, sans qu'il ne soit nécessaire d'avoir recours à des circuits de mesure complexes et plus sophistiqués. Il en résulte un calcul plus simple de la valeur de la capacité $C_{pt}$, tout en étant précis.

Le fonctionnement du dispositif 1' pour mesurer la tension électrique U de la phase électrique associée à la ligne 21 est analogue à celui du dispositif 1 décrit en référence à l'ordinogramme de la figure 3, à la différence près, notamment, que les capteurs 3 et 5 fonctionnent de concert, de sorte que :

- lors de l'étape 1000, les capteurs 3 et 5 sont accrochés simultanément à la ligne 21, au moyen du dispositif d'accrochage. Une fois ces capteurs 3 et 5 accrochés, le courant $I_1$ circule depuis la ligne 21 vers chacune des plaques 31 et 51.

- lors de l'étape 1002, le courant électrique $I_2$ est injecté par le générateur 7 au travers du conducteur 32 et du conducteur 52 et circule ensuite en direction de la ligne 21 par l'intermédiaire des plaques 31 et 51, de la masse électrique GND, des première et deuxième capacités plaque-terre $C_{pt1}$ et $C_{pt2}$ et de la capacité de ligne $C_L$.

- lors de l'étape 1004, le courant électrique $I_2$ injecté est mesuré dans les conducteurs 32 et 52, respectivement, via les appareils de mesure 4 et 6. Le fonctionnement du deuxième capteur de tension 62 est analogue à celui du premier capteur de tension 42, vis-à-vis du deuxième conducteur 52 et du courant de fuite $I_{F2}$. Le deuxième capteur de tension 62 délivre la valeur $U_{m2}$ comme résultat de la mesure.

- lors de l'étape 1006, l'unité 8 détermine la valeur de la capacité plaque-terre $C_{pt}$ en fonction des courants mesurés par chacun des appareils 4 et 6 lors de l'étape 1004. Par exemple, les tensions $U_{m1}$ et $U_{m2}$ sont acquises par l'unité 8. L'unité 8 calcule ensuite la valeur de la capacité plaque-terre $C_{pt}$ selon la formule (5) précédemment définie.

- lors d'une étape 1010, la tension U est déterminée par l'unité 8 à partir du courant $I_1$ mesuré par l'un ou l'autre des appareils 4 et 6 lors de l'étape 1008 et de la valeur de la capacité plaque-terre $C_{pt}$ calculée lors de l'étape 1006. Par exemple, la valeur de tension $U_{m1}$ mesurée lors de l'étape 1008 est acquise par l'unité 8. Le calcul de la tension U est alors effectué selon l'équation :

$$U \approx \frac{I_1}{\omega \times C_{pt}} \qquad (6)$$

## Revendications

1. Dispositif (1 ; 1') de mesure d'une grandeur électrique (U) d'une phase d'un premier courant électrique alternatif dans un réseau électrique aérien (2), ce dispositif comportant :

    - un capteur (3, 5), configuré pour être accroché à une ligne électrique (21, 22, 23) du réseau électrique aérien, ce capteur (3, 5) comprenant :

        une plaque (31, 51) électriquement conductrice,
        un conducteur électrique (32, 52), configuré pour raccorder électriquement la plaque à la ligne électrique, pour la circulation du premier courant électrique ($I_1$) depuis la ligne électrique à travers le conducteur électrique,

- une unité de calcul (8), configurée pour déterminer la grandeur électrique à partir d'une valeur du premier courant électrique ($I_1$) et d'une valeur d'une capacité électrique ($C_{pt}$) entre la plaque et le sol (10),

**caractérisé en ce que** le dispositif comporte en outre :

- un générateur (7), connecté électriquement au conducteur électrique et configuré pour injecter un deuxième courant électrique ($I_2$) à travers le conducteur électrique, ce deuxième courant électrique présentant une fréquence différente de la fréquence du premier courant électrique,

l'unité de calcul (8) étant en outre configurée pour calculer la valeur de la capacité électrique ($C_{pt}$) entre la plaque et le sol en fonction d'une valeur du deuxième courant électrique ($I_2$).

2. Dispositif (1') selon la revendication 1, **caractérisé en ce qu'**il comporte en outre :

- une deuxième plaque (51) électriquement conductrice,
- un deuxième conducteur électrique (52), configuré pour raccorder électriquement la deuxième plaque à la ligne électrique (21) pour la circulation d'au moins une partie du premier courant électrique (I1) depuis la ligne électrique vers la deuxième plaque (51) à travers le deuxième conducteur électrique, le deuxième conducteur électrique étant raccordé électriquement en sortie du générateur (7) pour la circulation d'au moins une partie du deuxième courant injecté à travers le deuxième conducteur.

3. Dispositif (1 ; 1') selon l'une des revendications 1 ou 2, **caractérisé en ce que** le dispositif comporte en outre un premier appareil de mesure (4) configuré pour mesurer le premier courant électrique ($I_1$) et le deuxième courant électrique ($I_2$) circulant à travers le conducteur électrique (32).

4. Dispositif selon la revendication 3, **caractérisé en ce que** le premier conducteur électrique (32) présente une première résistance électrique (41), le premier appareil de mesure (4) comportant un premier capteur de tension (42) pour mesurer la tension électrique aux bornes de la première résistance électrique (41).

5. Dispositif selon la revendication 2, **caractérisé en ce que** le dispositif comporte en outre un deuxième appareil (6) de mesure configuré pour mesurer le premier courant électrique ($I_1$) et le deuxième courant électrique ($I_2$) circulant à travers le deuxième conducteur électrique (52).

6. Dispositif selon la revendication 5, **caractérisé en ce que** le deuxième conducteur électrique (52) présente une deuxième résistance électrique (61), le deuxième appareil de mesure (6) comportant un deuxième capteur de tension (62) pour mesurer la tension électrique aux bornes de la deuxième résistance électrique (61).

7. Dispositif selon les revendications 4 et 6, **caractérisé en ce que** la capacité électrique $C_{pt}$ est calculée par l'unité de calcul (8) selon l'équation :

$$C_{pt} = \frac{U_{m1} - U_{m2}}{\omega \times R_m \left(1 - K'\right) \times \left(U_p - U_{m1}\right)}$$

où $U_{m1}$ et $U_{m2}$ sont, respectivement, les tensions électriques mesurées par les premier et deuxième appareils de mesure (4, 6), $\omega$ est la pulsation du courant alternatif circulant dans le réseau électrique aérien (2), $U_p$ est la tension électrique aux bornes du générateur (7) injectant le deuxième courant électrique ($I_2$), $R_m$ est égal à la valeur de la première résistance (41) et K' est une valeur numérique qui dépend du rapport entre la distance d'et la distance d, d étant la distance entre la première plaque (31) et la ligne électrique (21) et d' étant la distance entre la deuxième plaque (51) et la ligne électrique (21).

8. Dispositif (1') selon la revendication 7, **caractérisé en ce que** :

- lorsque le premier (3) et le deuxième (5) capteurs sont accrochés à la ligne électrique (21), le dispositif (1') comporte des première ($C_{ep1}$) et deuxième ($C_{ep2}$) capacités électriques parasites qui relient, respectivement, les première (31) et deuxième (51) plaques à la ligne électrique (21) et autorisent la circulation, depuis la ligne électrique, de premier ($I_{F1}$) et deuxième ($I_{F2}$) courants électriques de fuite,
- la valeur K' est égale au rapport entre le deuxième ($I_{F2}$) et premier ($I_{F1}$) courants électriques de fuite.

9. Dispositif selon l'une des revendications 1 à 8, **caractérisé en ce que** la fréquence du deuxième courant électrique injecté ($I_2$) est comprise entre 1 kHz et 1 MHz, de préférence entre 10 kHz et 100 kHz.

10. Dispositif selon l'une des revendications 1 à 9, **caractérisé en ce que** la grandeur électrique (U) est la tension de la phase du courant alternatif.

**11.** Procédé de mesure d'une grandeur électrique d'une phase d'un premier courant électrique alternatif dans un réseau électrique aérien (2), ce procédé comportant :

a) l'accrochage (1000) d'un capteur (3) à une ligne électrique aérienne (21) du réseau électrique, ce capteur (3) comprenant :

- une plaque (31) électriquement conductrice,
- un conducteur électrique (32), configuré pour raccorder électriquement la plaque à la ligne électrique, de sorte que le premier courant électrique ($I_1$) circule depuis la ligne électrique au travers du conducteur électrique,

b) la mesure (1008) du premier courant électrique circulant au travers du conducteur électrique, au moyen d'un appareil de mesure (4),
c) le calcul (1010) de la grandeur électrique (U), au moyen d'une unité de calcul (8), à partir du premier courant électrique mesuré et de la valeur de la capacité électrique ($C_{pt}$) entre la plaque (31) et le sol (51),

**caractérisé en ce que** le procédé comporte, préalablement à l'accrochage, une séquence d'étalonnage pour déterminer une valeur de la capacité électrique ($C_{pt}$), cette séquence d'étalonnage comprenant :

i) l'injection (1002), au moyen d'un générateur, d'un deuxième courant électrique ($I_2$) au travers du conducteur électrique, ce deuxième courant électrique présentant une fréquence différente de la fréquence du premier courant électrique,
ii) la mesure (1004), à l'aide de l'appareil de mesure (4), du deuxième courant électrique circulant dans le conducteur électrique,
iii) la détermination (1006) via l'unité de calcul (8) et en fonction du deuxième courant électrique mesuré, de la valeur de la capacité électrique ($C_{pt}$).

## Patentansprüche

**1.** Vorrichtung (1; 1') zum Messen einer elektrischen Größe (U) einer Phase eines ersten elektrischen Wechselstroms in einem elektrischen Freileitungsnetz (2), wobei diese Vorrichtung umfasst:

- einen Sensor (3, 5), der ausgebildet ist, an eine elektrische Leitung (21, 22, 23) des elektrischen Freileitungsnetzes befestigt zu werden, wobei dieser Sensor (3, 5) umfasst:

eine elektrisch leitende Platte (31, 51), einen elektrischen Leiter (32, 52), der ausgebildet ist, elektrisch die Platte mit der elektrischen Leitung für das Fließen des ersten elektrischen Stroms ($I_1$) von der elektrischen Leitung über den elektrischen Leiter zu verbinden,

- eine Berechnungseinheit (8), die ausgebildet ist, die elektrische Größe aus einem Wert des ersten elektrischen Stroms ($I_1$) und einem Wert einer elektrischen Kapazität ($C_{pt}$) zwischen der Platte und dem Boden (10) zu bestimmen,

**dadurch gekennzeichnet, dass** die Vorrichtung außerdem umfasst:

- einen Generator (7), der elektrisch mit dem elektrischen Leiter verbunden ist und ausgebildet ist, einen zweiten elektrischen Strom ($I_2$) über den elektrischen Leiter einzuspeisen, wobei dieser zweite elektrische Strom eine zu der Frequenz des ersten elektrischen Stroms unterschiedliche Frequenz aufweist,

wobei die Berechnungseinheit (8) außerdem ausgebildet ist, den Wert der elektrischen Kapazität ($C_{pt}$) zwischen der Platte und dem Boden abhängig von einem Wert des zweiten elektrischen Stroms ($I_2$) zu berechnen.

**2.** Vorrichtung (1') nach Anspruch 1, **dadurch gekennzeichnet, dass** sie außerdem umfasst:

- eine zweite elektrisch leitende Platte (51),
- einen zweiten elektrischen Leiter (52), der ausgebildet ist, die zweite Platte mit der elektrischen Leitung (21) für das Fließen mindestens eines Teils des ersten elektrischen Stroms ($I_1$) von der ersten elektrischen Leitung zu der zweiten Platte (51) über den zweiten elektrischen Leiter zu verbinden, wobei der zweite elektrische Leiter elektrisch an den Ausgang des Generators (7) für das Fließen mindestens eines Teils des zweiten, über den zweiten Leiter eingespeisten Stroms angeschlossen ist.

**3.** Vorrichtung (1; 1') nach einem der Ansprüche 1 oder 2, **dadurch gekennzeichnet, dass** die Vorrichtung außerdem ein erstes Messgerät (4) aufweist, das ausgebildet ist, den ersten elektrischen Strom ($I_1$) und den zweiten elektrischen Strom ($I_2$) zu messen, die über den elektrischen Leiter (32) fließen.

**4.** Vorrichtung nach Anspruch 3, **dadurch gekennzeichnet, dass** der erste elektrische Leiter (32) einen ersten elektrischen Widerstand (41) aufweist, wobei das erste Messgerät (4) einen ersten Spannungssensor (42) zum Messen der elektrischen Spannung an den Anschlüssen des ersten elektrischen Widerstandes (41) aufweist.

5. Vorrichtung nach Anspruch 2, **dadurch gekennzeichnet, dass** die Vorrichtung außerdem ein zweites Messgerät (6) aufweist, das zum Messen des ersten elektrischen Stroms ($I_1$) und des zweiten elektrischen Stroms ($I_2$) ausgebildet ist, die über den zweiten elektrischen Leiter (52) fließen.

6. Vorrichtung nach Anspruch 5, **dadurch gekennzeichnet, dass** der zweite elektrische Leiter (52) einen zweiten elektrischen Widerstand (61) aufweist, wobei das zweite Messgerät (6) einen zweiten Spannungssensor (62) zum Messen der elektrischen Spannung an den Anschlüssen des zweiten elektrischen Widerstandes (61) aufweist.

7. Vorrichtung nach den Ansprüchen 4 und 6, **dadurch gekennzeichnet, dass** die elektrische Kapazität ($C_{pt}$) von der Berechnungseinheit (8) nach der Gleichung berechnet wird:

$$C_{pt} = \frac{U_{m1} - U_{m2}}{\omega \times R_m (1 - K') \times (U_p - U_{m1})}$$

wobei $U_{m1}$ und $U_{m2}$ jeweils die von dem ersten und zweiten Messgerät (4, 6) gemessenen elektrischen Spannungen sind, $\omega$ die Schwingung des in dem Freileitungsnetz (2) fließenden Wechselstroms ist, $U_p$ die elektrische Spannung an den Klemmen des den zweiten elektrischen Strom ($I_2$) einspeisenden Generators (7) ist, $R_m$ gleich dem Wert des ersten Widerstandes (41) ist und K' ein numerischer Wert ist, der von dem Verhältnis zwischen der Entfernung d' und der Entfernung d abhängt, wobei d der Abstand zwischen der ersten Platte (31) und der elektrischen Leitung (21) ist und d' der Abstand zwischen der zweiten Platte (51) und der elektrischen Leitung (21) ist.

8. Vorrichtung (1') nach Anspruch 7, **dadurch gekennzeichnet, dass**:

   - wenn der erste (3) und der zweite (5) Sensor an der elektrischen Leitung (21) befestigt sind, die Vorrichtung (1') eine erste ($C_{ep1}$) und zweite elektrische ($C_{ep2}$) parasitäre Kapazität aufweist, die jeweils die erste (31) und zweite (51) Platte an die elektrische Leitung (21) anschließen und das Fließen eines ersten ($I_{F1}$) und zweiten Ableitstroms ($I_{F2}$) von der elektrischen Leitung ermöglichen,
   - der Wert K' gleich dem Verhältnis zwischen dem ersten und zweiten elektrischen Ableitstrom ist.

9. Vorrichtung nach einem der Ansprüche 1 bis 8, **dadurch gekennzeichnet, dass** die Frequenz des zweiten eingespeisten elektrischen Stroms ($I_2$) zwischen 1 kHz und 1 MHz, vorzugsweise zwischen 10 kHz und 100 kHz liegt.

10. Vorrichtung nach einem der Ansprüche 1 bis 9, **dadurch gekennzeichnet, dass** die elektrische Größe (U) die Spannung der Phase des Wechselstroms ist.

11. Verfahren zum Messen einer elektrischen Größe einer Phase eines ersten elektrischen Wechselstroms in einem elektrischen Freiluftnetz (2), wobei das Verfahren aufweist:

   a) Befestigen (1000) eines Sensors (3) an eine elektrische Freiluftleitung (21) des elektrischen Netzes, wobei dieser Sensor (3) umfasst:

      - eine elektrisch leitende Platte (31),
      - einen elektrischen Leiter (32), der ausgebildet ist, elektrisch die Platte mit der elektrischen Leitung zu verbinden, derart dass der erste elektrische Strom ($I_1$) von der elektrischen Leitung über den elektrischen Leiter fließt,

   b) Messen (1008) des ersten über den elektrischen Leiter fließenden elektrischen Stroms mittels eines Meßgeräts (4),
   c) Berechnen (1010) der elektrischen Größe (U) mittels einer Berechnungseinheit (8) aus dem ersten gemessenen elektrischen Strom und dem Wert der elektrischen Kapazität ($C_{pt}$) zwischen der Platte (31) und dem Boden (51),

   **dadurch gekennzeichnet, dass** das Verfahren vor dem Befestigen eine Kalibriersequenz aufweist, um einen Wert der elektrischen Kapazität ($C_{pt}$) zu bestimmen, wobei diese Kalibriersequenz umfasst:

      i) Einspeisen (1002) mittels eines Generators eines zweiten elektrischen Stroms ($I_2$) über den elektrischen Leiter, wobei dieser zweite elektrische Strom eine zu der Frequenz des ersten elektrischen Stroms unterschiedliche Frequenz aufweist,
      ii) Messen (1004) mithilfe des Messgerät (4) eines zweiten elektrischen Stroms ($I_2$), der in dem elektrischen Leiter fließt,
      iii) Bestimmen (1006) des Wertes der elektrischen Kapazität ($C_{pt}$) über die Berechnungseinheit (8) und abhängig von dem zweiten gemessenen elektrischen Strom.

## Claims

1. A device (1; 1') for measuring an electrical quantity (U) of one phase of an AC electric current of an overhead electrical network (2), this device including:

   - a sensor (3, 5), configured to be attached to an electric line (21, 22, 23) of the overhead electrical network, this sensor (3, 5) comprising:

     an electrically conductive plate (31, 51), an electrical conductor (32, 52), configured to electrically connect the plate to the electric line, for the circulation of the first electric current ($I_1$) from the electric line through the electrical conductor,

   - a computation unit (8), configured to determine the electrical quantity from a value of the first electric current ($I_1$) and a value of an electrical capacity ($C_{pt}$) between the plate and the ground (10),

   **characterized in that** the device further includes:

   - a generator (7), electrically connected to the electrical conductor and configured to inject a second electric current (12) through the electrical conductor, this second electric current having a frequency different from the frequency of the first electric current,

   the computation unit (8) further being configured to compute the value of the electrical capacity ($C_{pt}$) between the plate and the ground as a function of a value of the second electric current ($I_2$).

2. The device (1') according to claim 1, **characterized in that** it further includes:

   - a second electrically conductive plate (51),
   - a second electrical conductor (52), configured to electrically connect the second plate to the electric line (21) for the circulation of at least part of the first electric current (11) from the electric line to the second plate (51) through the second electrical conductor, the second electrical conductor being electrically connected to the output of the generator (7) for the circulation of at least part of the second current injected through the second conductor.

3. The device (1; 1') according to one of claims 1 or 2, **characterized in that** the device further includes a first measuring apparatus (4) configured to measure the first electric current ($I_1$) and the second electric current (12) circulating through the electrical conductor (32).

4. The device according to claim 3, **characterized in that** the first electrical conductor (32) has a first resistance (41), the first measuring apparatus (4) including a first voltage sensor (42) to measure the electric voltage across the terminals of the first resistance (41).

5. The device according to claim 2, **characterized in that** the device further includes a second measuring apparatus (6) configured to measure the first electric current ($I_1$) and the second electric current ($I_2$) circulating through the second electrical conductor (52).

6. The device according to claim 5, **characterized in that** the second electrical conductor (52) has a second resistance (61), the second measuring apparatus (6) including a second voltage sensor (62) to measure the electric voltage across the terminals of the second resistance (61).

7. The device according to claims 4 and 6, **characterized in that** the electrical capacity $C_{pt}$ is computed by the computation unit (8) according to the equation:

$$C_{pt} = \frac{U_{m1} - U_{m2}}{\omega \times R_m(1 - K') \times (U_p - U_{m1})}$$

   where $U_{m1}$ and $U_{m2}$ are respectively the electric voltages measured by the first and second measuring apparatuses (4, 6), $\omega$ is the pulse of the AC current circulating in the overhead electrical network (2), $U_p$ is the electric voltage across the terminals of the generator (7) injecting the second electric current ($I_2$), $R_m$ is equal to the value of the first resistance (41) and K' is a numerical value that depends on the ratio between the distance d' and the distance d, d being the distance between the first plate (31) and the electric line (21) and d' being the distance between the second plate (51) and the electric line (21).

8. The device (1') according to claim 7, **characterized in that**:

   - when the first (3) and second (5) sensors are attached to the electric line (21), the device (1') includes first ($C_{ep1}$) and second ($C_{ep2}$) stray electrical capacities that respectively connect the first (31) and second (51) plates to the electric line (21) and allow the circulation, from the electric line, of first ($I_{F1}$) and second ($I_{F2}$) electric leak currents,
   - the value K' is equal to the ratio between the second ($I_{F2}$) and first ($I_{F1}$) electric leak currents.

9. The device according to one of claims 1 to 8, **characterized in that** the frequency of the second inject-

ed electric current ($I_2$) is comprised between 1 kHz and 1 MHz, preferably between 10 kHz and 100 kHz.

10. The device according to one of claims 1 to 9, **characterized in that** the electrical quantity (U) is the voltage of the phase of the AC current.

11. A method for measuring an electrical quantity of one phase of an AC electric current of an overhead electrical network (2), this method including:

a) attaching (1000) a sensor (3) to an overhead electric line (21) of the electrical network, this sensor (3) comprising:

- an electrically conductive plate (31),
- an electrical conductor (32), configured to electrically connect the plate to the electric line, such that the first electric current ($I_1$) circulates from the electric line through the electrical conductor,

b) measuring (1008) the first electric current circulating through the electrical conductor, using a measuring apparatus (4),
c) computing (1010) an electrical quantity (U), using a computation unit (8), from the measured first electric current and the value of the electrical capacity ($C_{pt}$) between the plate (31) and the ground (51),

**characterized in that** the method includes, before the attachment, a calibration sequence to determine a value of the electrical capacity ($C_{pt}$), this calibration sequence comprising:

i) injecting (1002), using a generator, a second electric current ($I_2$) through the electrical conductor, this second electric current having a frequency different from the frequency of the first electric current,
ii) measuring (1004), using the measuring apparatus (4), the second electric current circulating in the electrical conductor,
iii) determining (1006), via the computation unit (8) and based on the measured second electric current, the value of the electrical capacity ($C_{pt}$).

**Fig.1**

**Fig.2**

Fig.4

Fig.3

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20150077088 A1

- US 2014035595 A1